# EUROPEAN PATENT APPLICATION

(11) **EP 4 556 925 A2**
(43) Date of publication of application: **21.05.2025**
(21) Application number: 23912901.8
(22) Date of filing: 26.12.2023
(51) Int. Cl.: G01R 31/396, G01R 31/367, G01R 31/385, B60L 58/10, H01M 10/0525, G01R 31/382, G01R 19/12, G01R 19/165, G01R 31/3835, G01R 31/392

(54) **APPARATUS AND METHOD FOR MANAGING BATTERY**

(30) Priority: 26.12.2022 KR 20220185033; 26.12.2022 KR 20220185081; 28.12.2022 KR 20220187182; 12.09.2023 KR 20230121415
(71) Applicant: LG Energy Solution, Ltd., Seoul 07335 (KR)
(72) Inventor: YOON, Seo-Young, Daejeon 34122 (KR); CHOI, Soon-Ju, Daejeon 34122 (KR); CHOI, Soon-Hyung, Daejeon 34122 (KR); KIM, Dae-Soo, Daejeon 34122 (KR); KIM, Young-Deok, Daejeon 34122 (KR)
(74) Representative: Goddar, Heinz J.
(86) International application number: PCT/KR2023/021620
(87) International publication number: WO 2024/144226

(57) **Abstract**

An apparatus for managing a battery according to one aspect of the present disclosure may include a profile obtaining unit configured to obtain a measurement full-cell profile indicating a corresponding relationship between voltage and capacity of a battery; a profile determining unit configured to adjust a preset criterion positive electrode profile and a preset criterion negative electrode profile to correspond to the measurement full-cell profile or a plurality of sections of the measurement full-cell profile, and generate an adjusted positive electrode profile and an adjusted negative electrode profile according to the adjustment result; and a control unit configured to determine a diagnosis factor for the battery from at least one of the adjusted positive electrode profile and the adjusted negative electrode profile.

## Description

### TECHNICAL FIELD

The present application claims priority to Korean Patent Application No. 10-2022-0185033 and No. 10-2022-0185081 filed on December 26, 2022 in the Republic of Korea, Korean Patent Application No. 10-2022-0187182 filed on December 28, 2022 in the Republic of Korea, and Korean Patent Application No. 10-2023-0121415 filed on September 12, 2023 in the Republic of Korea, the disclosures of which are incorporated herein by reference.

The present disclosure relates to an apparatus and method for managing a battery, and more particularly, to an apparatus and method for managing a battery, which estimates a positive electrode profile and a negative electrode profile of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

A lot of research is being conducted on these batteries in terms of high-capacity and high-density, but the aspect of improving lifespan and safety is also important. In order to improve the safety of the battery, the current state of the battery must be accurately diagnosed.

In order to most accurately diagnose the current state of the battery, the positive electrode profile and the negative electrode profile of the battery must be secured and analyzed separately. However, since disassembly and assembly of the manufactured battery are virtually impossible, there is a problem that it is impossible to directly measure the positive electrode profile and negative electrode profile of the manufactured battery. Therefore, in order to more accurately diagnose the state of the battery, technology is required to accurately estimate the positive electrode profile and the negative electrode profile corresponding to the battery.

### DISCLOSURE

### Technical Problem

The present disclosure is designed to solve the problems of the related art, and therefore the present disclosure is directed to providing an apparatus and method for managing a battery that can accurately estimate the positive electrode profile and the negative electrode profile corresponding to the battery

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for managing a battery according to one aspect of the present disclosure may comprise a profile obtaining unit configured to obtain a measurement full-cell profile indicating a corresponding relationship between voltage and capacity of a battery; a profile determining unit configured to adjust a preset criterion positive electrode profile and a preset criterion negative electrode profile to correspond to the measurement full-cell profile or the plurality of sections of the measurement full-cell profile, and generate an adjusted positive electrode profile and an adjusted negative electrode profile according to the adjustment result; and a control unit configured to determine a diagnosis factor for the battery from at least one of the adjusted positive electrode profile and the adjusted negative electrode profile.

The profile obtaining unit may be configured to further obtain a full-cell differential profile corresponding to the measurement full-cell profile and indicating a corresponding relationship between capacity and differential voltage.

The profile determining unit may be configured to divide the measurement full-cell profile into the plurality of sections based on at least one of a plurality of peaks included in the full-cell differential profile.

The profile determining unit may be configured to divide the measurement full-cell profile into the plurality of sections based on capacities of the plurality of peaks included in the full-cell differential profile.

The profile determining unit may be configured to generate the adjusted positive electrode profile and the adjusted negative electrode profile corresponding to each of the plurality of sections by adjusting the criterion positive electrode profile and the criterion negative electrode profile to correspond to each of the plurality of sections.

The profile determining unit may be configured to generate a plurality of adjusted positive electrode profiles such that an end point of the adjusted positive electrode profile for a previous section is the same as a start point of the adjusted positive electrode profile for a next section, and generate a plurality of adjusted negative electrode profiles such that an end point the adjusted negative electrode profile for the previous section is the same as the start point of the adjusted negative electrode profile for the next section.

The profile determining unit may be configured to divide the measurement full-cell profile into the plurality of sections based on a plurality of reference peaks included in the full-cell differential profile.

The profile determining unit may be configured to set a weight for each of the plurality of sections and adjust the criterion positive electrode profile and the criterion negative electrode profile based on the weight to correspond to the measurement full-cell profile.

The profile determining unit may be configured to set the weight for a target section containing at least one of the plurality of target peaks included in the full-cell differential profile to be larger than the weight for the remaining sections.

The profile determining unit may be configured to generate a comparison full-cell profile based on the adjusted positive electrode profile and the adjusted negative electrode profile, and adjust the criterion positive electrode profile and the criterion negative electrode profile such that as the section has a larger set weight, an error rate between the comparison full-cell profile and the measurement full-cell profile is lowered.

The profile obtaining unit may be configured to obtain at least one of a positive electrode differential profile corresponding to the criterion positive electrode profile and a negative electrode differential profile corresponding to the criterion negative electrode profile as an electrode differential profile.

The profile determining unit may be configured to divide a corresponding criterion electrode profile among the criterion positive electrode profile and the criterion negative electrode profile into a plurality of electrode sections based on at least one of a plurality of electrode peaks included in the electrode differential profile, and adjust the criterion positive electrode profile and the criterion negative electrode profile to correspond to the measurement full-cell profile, while adjusting each of the plurality of electrode sections.

The profile determining unit may be configured to independently adjust each of the plurality of electrode sections.

When the positive electrode differential profile is included in the electrode differential profile, the profile determining unit may be configured to divide the criterion positive electrode profile into a plurality of positive electrode sections based on at least one of the plurality of positive electrode peaks included in the positive electrode differential profile.

When the negative electrode differential profile is included in the electrode differential profile, the profile determining unit may be configured to divide the criterion negative electrode profile into a plurality of negative electrode sections based on at least one of the plurality of negative electrode peaks included in the negative electrode differential profile.

A battery pack according to another aspect of the present disclosure may comprise the apparatus for managing a battery according to the present disclosure.

A vehicle according to still another aspect of the present disclosure may comprise the apparatus for managing a battery according to the present disclosure.

A method for managing a battery according to still another aspect of the present disclosure may comprise a profile obtaining step of obtaining a measurement full-cell profile indicating a corresponding relationship between voltage and capacity of a battery; a profile adjusting step of adjusting a preset criterion positive electrode profile and a preset criterion negative electrode profile to correspond to the measurement full-cell profile or the plurality of sections of the measurement full-cell profile; a profile generating step of generating an adjusted positive electrode profile and an adjusted negative electrode profile according to the adjustment result; and a factor determining step of determining a diagnosis factor for the battery from at least one of the adjusted positive electrode profile and the adjusted negative electrode profile.

### Advantageous Effects

According to one aspect of the present disclosure, the apparatus for managing a battery has an advantage of estimating the positive electrode profile and the negative electrode profile of a battery, which cannot be measured directly, by adjusting the criterion positive electrode profile and the criterion negative electrode profile.

Additionally, because the apparatus for managing a battery can determine a diagnosis factor indicating the current state of the battery, the current state of the battery can be diagnosed based on the diagnosis factor. In other words, the apparatus for managing a battery has an advantage of determining diagnosis factors that can diagnose the current state of the battery in a non-destructive manner.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for managing a battery according to an embodiment of the present disclosure.
FIG. 2 is a diagram showing a measurement full-cell profile according to an embodiment of the present disclosure.
FIG. 3 is a diagram showing a criterion positive electrode profile, a criterion negative electrode profile, and a criterion full-cell profile according to an embodiment of the present disclosure.
FIG. 4 is a diagram showing the measurement full-cell profile and the criterion full-cell profile according to an embodiment of the present disclosure.
FIG. 5 is a diagram showing the criterion full-cell profile and the comparison full-cell profile according to an embodiment of the present disclosure.
FIG. 6 is a diagram showing a full-cell differential profile according to an embodiment of the present disclosure.
FIG. 7 is a diagram showing the measurement full-cell profile and a plurality of sections according to an embodiment of the present disclosure.
FIG. 8 is a diagram showing the measurement full-cell profile and the first comparison full-cell profile according to an embodiment of the present disclosure.
FIG. 9 is a diagram showing a full-cell differential profile according to an embodiment of the present disclosure.
FIG. 10 is a diagram showing the measurement full-cell profile and a plurality of sections according to an embodiment of the present disclosure.
FIG. 11 is a diagram showing the measurement full-cell profile and the second comparison full-cell profile according to an embodiment of the present disclosure.
FIG. 12 is a diagram showing a positive electrode differential profile according to an embodiment of the present disclosure.
FIG. 13 is a diagram showing a negative electrode differential profile according to an embodiment of the present disclosure.
FIG. 14 is a diagram showing a criterion positive electrode profile and a criterion negative electrode profile according to an embodiment of the present disclosure.
FIG. 15 is a diagram showing the measurement full-cell profile and the third comparison full-cell profile according to an embodiment of the present disclosure.
FIG. 16 is a diagram showing an exemplary configuration of a battery pack according to another embodiment of the present disclosure.
FIG. 17 is a diagram schematically showing a vehicle according to still another embodiment of the present disclosure.
FIG. 18 is a diagram schematically showing a method for managing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

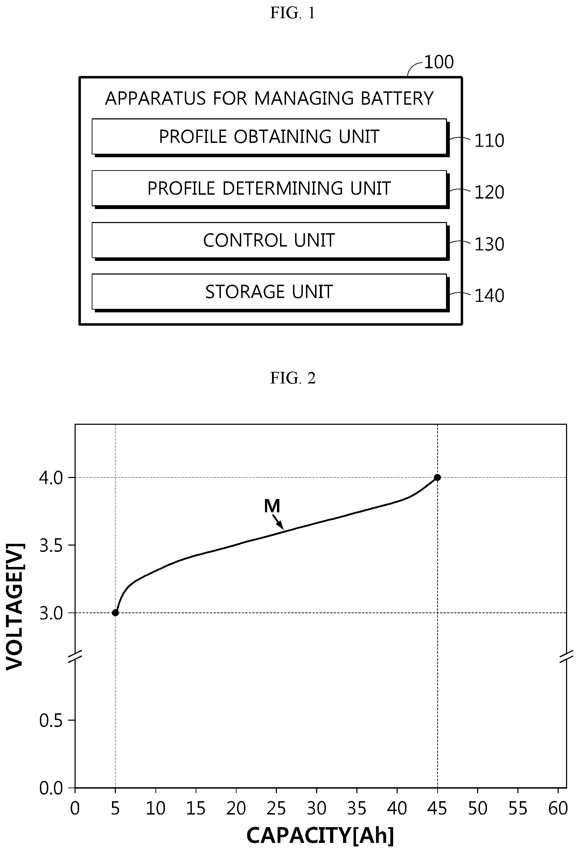

FIG. 1 is a diagram schematically showing an apparatus 100 for managing a battery according to an embodiment of the present disclosure.

Referring to FIG. 1, the apparatus 100 for managing a battery may include a profile obtaining unit 110, a profile determining unit 120, and a control unit 130.

Here, the battery refers to an independent cell that has a negative terminal and a positive terminal and is physically separable. As an example, a lithium-ion battery or a lithium polymer battery may be considered as a battery. Additionally, the type of battery may be a cylindrical type, a prismatic type, or a pouch type. Additionally, the battery may mean a battery bank, a battery module or a battery pack in which a plurality of cells are connected in series and/or parallel. Below, for convenience of explanation, the battery is explained as meaning one independent cell.

The profile obtaining unit 110 may be configured to obtain a measurement full-cell profile M indicating the corresponding relationship between the voltage and capacity of the battery.

Specifically, the measurement full-cell profile M is a profile that represents the corresponding relationship between voltage (V) and capacity (Q) when the SOC of the battery is charged from 0% to 100%.

For example, there is no special limitation on the C-rate in charging or discharging to generate the measurement full-cell profile M. However, preferably, in order to obtain more accurate measurement full-cell profile M and full-cell differential profile D, the battery should be charged or discharged at a low rate. For example, in the process of charging or discharging a battery at 0.05 C, a measurement full-cell profile M may be generated.

For example, the profile obtaining unit 110 may directly receive the measurement full-cell profile M of the battery from the outside. That is, the profile obtaining unit 110 can obtain the measurement full-cell profile M by being connected to the outside by wired and/or wirelessly and receiving the measurement full-cell profile M.

As another example, the profile obtaining unit 110 may receive battery information about the voltage and capacity of the battery. Also, the profile obtaining unit 110 can obtain the measurement full-cell profile M by generating the measurement full-cell profile M based on the received battery information.

FIG. 2 is a diagram showing a measurement full-cell profile M according to an embodiment of the present disclosure.

For example, in the embodiment of FIG. 2, the measurement full-cell profile M can be expressed as a two-dimensional X-Y graph with the X-axis set to capacity [Ah] and the Y-axis set to voltage [V].

The profile obtaining unit 110 may be connected to communicate with the control unit 130. For example, the profile obtaining unit 110 may be connected to the control unit 130 wired and/or wirelessly. The profile obtaining unit 110 may transmit the obtained measurement full-cell profile M to the profile determining unit 120.

The profile determining unit 120 may be configured to adjust the preset criterion positive electrode profile Rp and the preset criterion negative electrode profile Rn to correspond to the measurement full-cell profile M or a plurality of sections of the measurement full-cell profile M.

Here, the criterion positive electrode profile Rp may be a profile representing a correspondence relationship between the capacity and voltage of the preset criterion positive electrode cell to correspond to the positive electrode of the battery. For example, the criterion positive electrode cell may be a positive electrode coin half-cell or a positive electrode of a three-electrode cell. Additionally, the criterion negative electrode profile Rn may be a profile representing a correspondence relationship between the capacity and voltage of the preset criterion negative electrode cell to correspond to the negative electrode of the battery. For example, the criterion negative electrode cell may be a negative electrode coin half-cell or a negative electrode of a three-electrode cell.

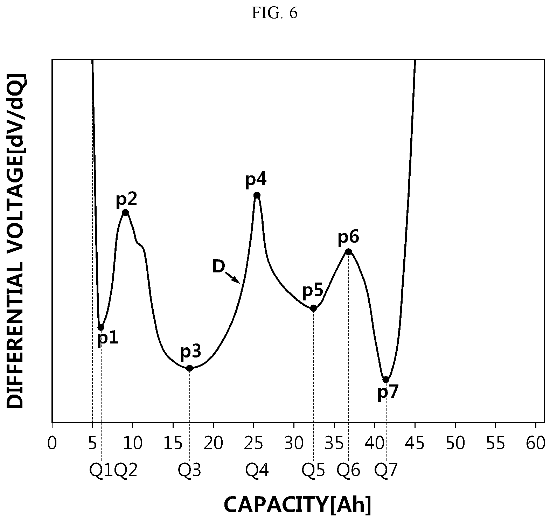

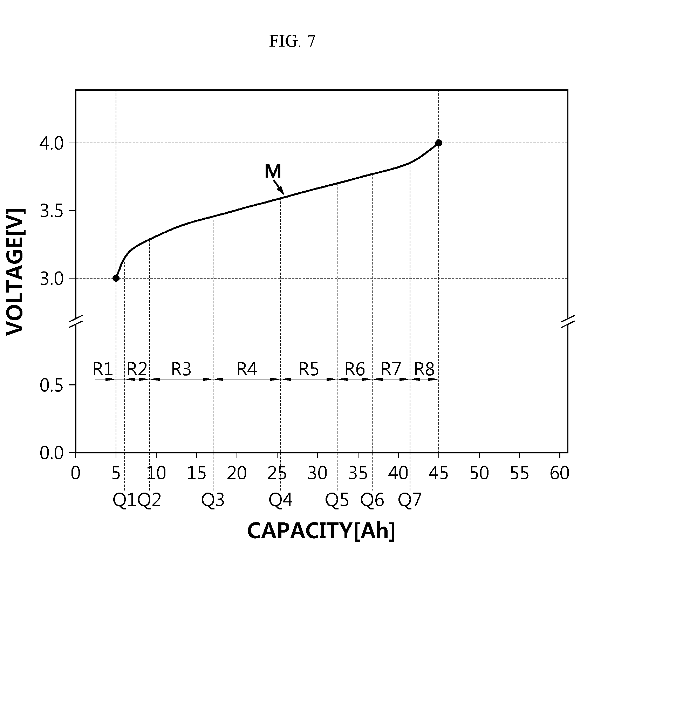

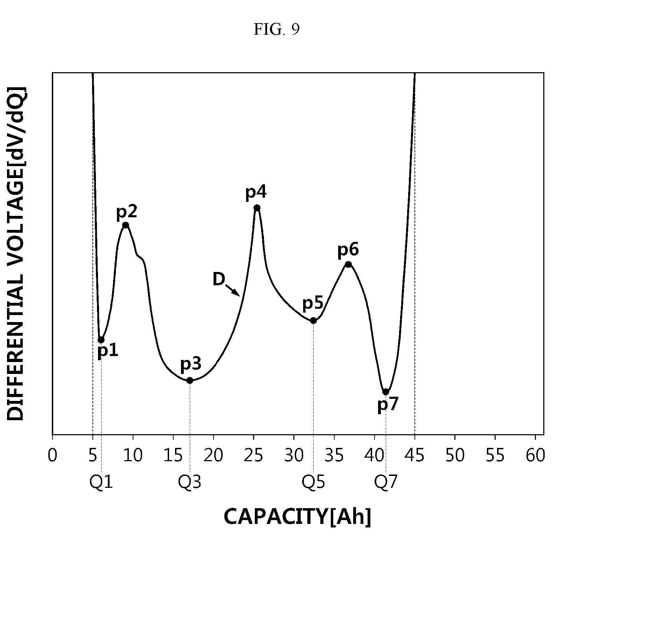

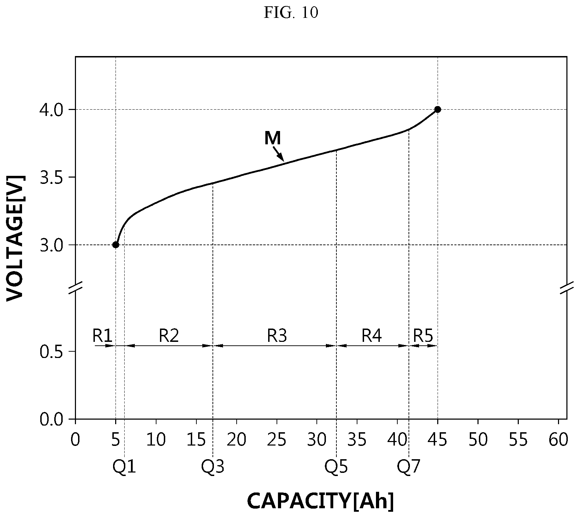

Specifically, the profile determining unit 120 may determine whether the measurement full-cell profile M is divided into a plurality of sections according to a predetermined capacity criterion. For example, the profile determining unit 120 may determine whether the entire capacity section of the measurement full-cell profile M is divided into a plurality of sections. As a specific example, the profile determining unit 120 may determine whether the measurement full-cell profile M is divided into a plurality of sections based on a first capacity criterion (see FIGS. 6 and 7) or a second capacity criterion (see FIGS. 9 and 10).

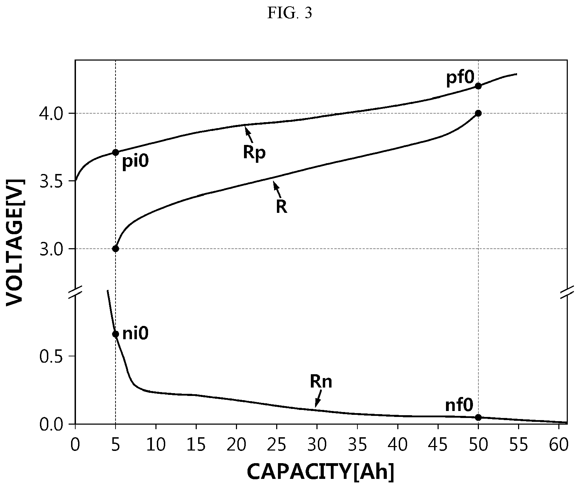

FIG. 3 is a diagram showing a criterion positive electrode profile Rp, a criterion negative electrode profile Rn, and a criterion full-cell profile R according to an embodiment of the present disclosure.

In the embodiment of FIG. 3, in the criterion positive electrode profile Rp, the positive electrode participation start point is pi0, and the positive electrode participation end point is pf0. In the criterion negative electrode profile Rn, the negative electrode participation start point is ni0, and the negative electrode participation end point is nf0. The criterion full-cell profile R is a criterion for the same capacity and can be expressed as the difference between the positive electrode potential of the criterion positive electrode profile Rp and the negative electrode potential of the criterion negative electrode profile Rn.

Specifically, depending on whether the measurement full-cell profile M is divided, the adjustment target of the criterion positive electrode profile Rp and the criterion negative electrode profile Rn may be different as the entire section of the measurement full-cell profile M or each section of the measurement full-cell profile M.

For example, when the measurement full-cell profile M is not divided into a plurality of sections, the profile determining unit 120 may adjust the criterion positive electrode profile Rp and the criterion negative electrode profile Rn to correspond to the entire section of the measurement full-cell profile M. Here, one adjustment result for the criterion positive electrode profile Rp and the criterion negative electrode profile Rn can be derived.

Specifically, the profile determining unit 120 may generate a plurality of comparison full-cell profiles S by shifting the criterion positive electrode profile Rp and the criterion negative electrode profile Rn or performing capacity scaling thereto, and specify a comparison full-cell profile S having the minimum error with the measurement full-cell profile M among the plurality of comparison full-cell profiles S. Also, the adjusted positive electrode profile Rp' and the adjusted negative electrode profile Rn' corresponding to the specified comparison full-cell profile S can be determined.

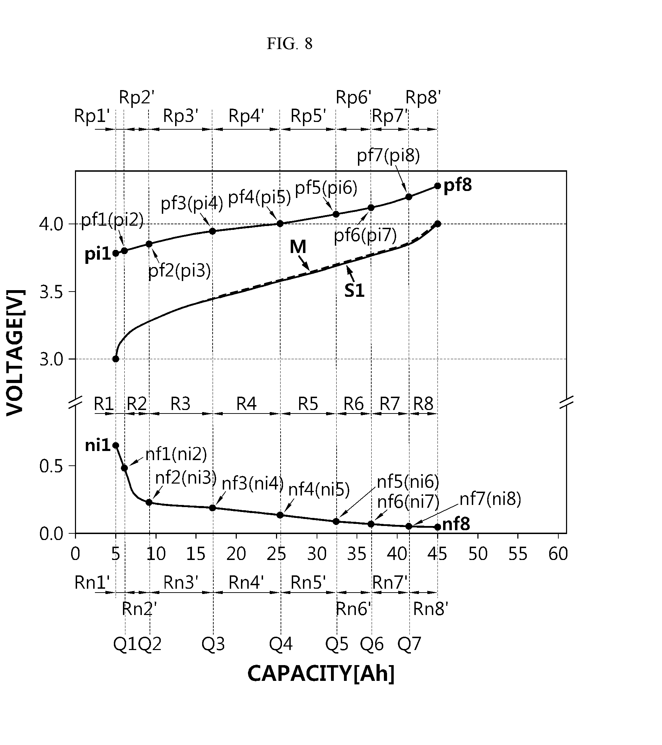

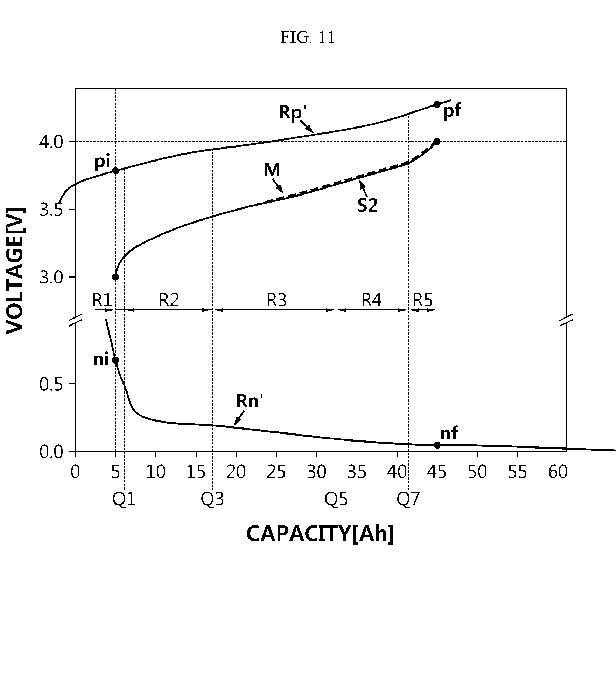

As another example, when the measurement full-cell profile M is divided into a plurality of sections, the profile determining unit 120 can adjust the criterion positive electrode profile Rp and the criterion negative electrode profile Rn to correspond to each section of the measurement full-cell profile M. If the measurement full-cell profile M is divided into n sections (where n is a natural number), the criterion positive electrode profile Rp and the criterion negative electrode profile Rn can be adjusted to correspond to each of the n sections. That is, one adjustment result (see FIG. 11) or n adjustment results (see FIG. 8) for the criterion positive electrode profile Rp and the criterion negative electrode profile Rn can be derived.

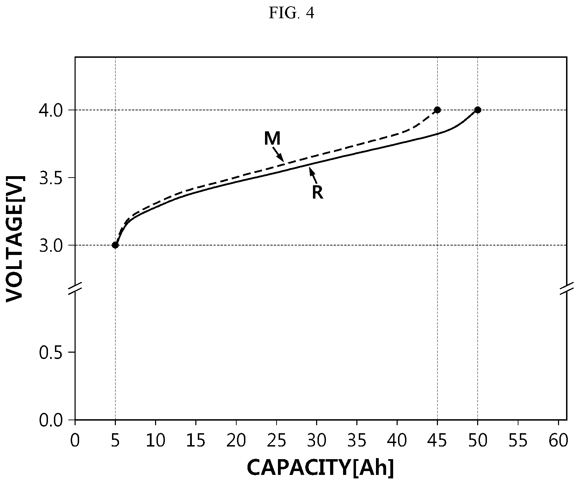

FIG. 4 is a diagram showing the measurement full-cell profile M and the criterion full-cell profile R according to an embodiment of the present disclosure.

In the embodiment of FIG. 4, the criterion full-cell profile R and the measurement full-cell profile M may be different so that they do not correspond to each other. For example, the voltage sections of the measurement full-cell profile M and the criterion full-cell profile R may be the same as 3.0 [V] to 4.0 [V], but the capacity section of the measurement full-cell profile M may be 5 [Ah] to 45 [Ah], and the capacity section of the criterion full-cell profile R may be 5 [Ah] to 50 [Ah]. Since the criterion full-cell profile R and the measurement full-cell profile M are different, the profile determining unit 120 can adjust the criterion positive electrode profile Rp and the criterion negative electrode profile Rn to correspond to the measurement full-cell profile M.

The profile determining unit 120 may be configured to generate an adjusted positive electrode profile Rp' and an adjusted negative electrode profile Rn' according to the adjustment result.

Specifically, the adjusted positive electrode profile Rp' is the result of adjusting the criterion positive electrode profile Rp, and the adjusted negative electrode profile Rn' is the result of adjusting the criterion negative electrode profile Rn. In other words, the comparison full-cell profile S is specified according to the adjustment result of the criterion positive electrode profile Rp and the criterion negative electrode profile Rn, and the basis of the comparison full-cell profile S is the adjusted positive electrode profile Rp' and the adjusted negative electrode profile Rn'. Therefore, the adjusted positive electrode profile Rp' and the adjusted negative electrode profile Rn' can be strongly estimated as the positive electrode profile and the negative electrode profile of the battery.

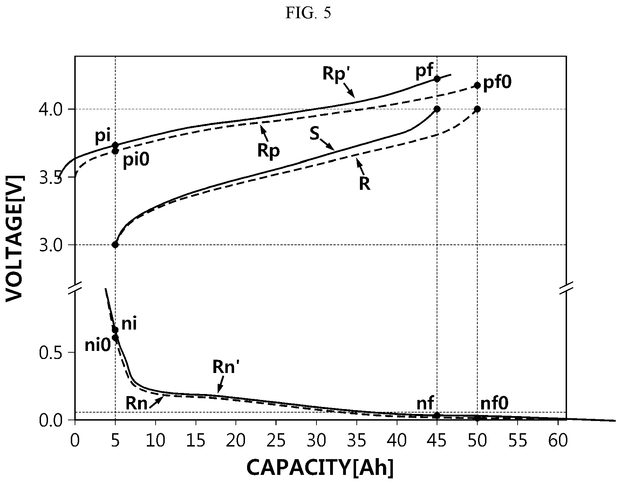

FIG. 5 is a diagram showing the criterion full-cell profile R and the comparison full-cell profile S according to an embodiment of the present disclosure.

For example, in the embodiment of FIG. 5, the criterion positive electrode profile Rp can be adjusted to the adjusted positive electrode profile Rp', and the criterion negative electrode profile Rn can be adjusted to the adjusted negative electrode profile Rn'. In other words, the criterion full-cell profile R can be adjusted to the comparison full-cell profile S. Specifically, the positive electrode participation start point pi0 of the criterion positive electrode profile Rp can be adjusted to the positive electrode participation start point pi of the adjusted positive electrode profile Rp', and the positive electrode participation end point pf0 of the criterion positive electrode profile Rp can be adjusted to the positive electrode participation end point pf of the adjusted positive electrode profile Rp'. The negative electrode participation start point ni0 of the criterion negative electrode profile Rn can be adjusted to the negative electrode participation start point ni of the adjusted negative electrode profile Rn', and the negative electrode participation end point nf0 of the criterion negative electrode profile Rn can be adjusted to the negative electrode participation end point nf of the adjusted negative electrode profile Rn'.

The control unit 130 may be configured to determine a diagnosis factor for the battery from at least one of the adjusted positive electrode profile Rp' and the adjusted negative electrode profile Rn'.

Specifically, the diagnosis factor may include at least one of the positive electrode factor and the negative electrode factor. That is, the control unit 130 may be configured to determine the positive electrode factor for the battery from the adjusted positive electrode profile Rp'. Additionally, the control unit 130 may be configured to determine the negative electrode factor for the battery from the adjusted negative electrode profile Rn'.

For example, the positive electrode factor may include the positive electrode participation start point pi, the positive electrode participation end point pf, and the positive electrode change rate ps.

The positive electrode participation start point pi is the start point of the adjusted positive electrode profile Rp'. For example, in the embodiment of FIG. 5, the positive electrode participation start point pi is a point corresponding to capacity 5 [Ah] in the adjusted positive electrode profile Rp'.

The positive electrode participation end point pf is the end point of the adjusted positive electrode profile Rp'. For example, in the embodiment of FIG. 5, the positive electrode participation end point pf is a point corresponding to capacity 45 [Ah] in the adjusted positive electrode profile Rp'.

The positive electrode change rate ps may mean the change rate [%] of the adjusted positive electrode profile Rp' with respect to the criterion positive electrode profile Rp. Specifically, the positive electrode change rate ps may be the contraction ratio or expansion ratio of the adjusted positive electrode profile Rp' with respect to the criterion positive electrode profile Rp. For example, if the adjusted positive electrode profile Rp' is 10% shrinkage from the criterion positive electrode profile Rp, the positive electrode change rate ps is 90%. Conversely, if the adjusted positive electrode profile Rp' is 10% extension from the criterion positive electrode profile Rp, the positive electrode change rate ps is 110%.

As another example, the negative electrode factor may include the negative electrode participation start point ni, the negative electrode participation end point nf, and the negative electrode change rate ns.

The negative electrode participation start point ni is the start point of the adjusted negative electrode profile Rn'. For example, in the embodiment of FIG. 5, the negative electrode participation start point ni is a point corresponding to capacity 5 [Ah] in the adjusted negative electrode profile Rn'.

The negative electrode participation end point nf is the end point of the adjusted negative electrode profile Rn'. For example, in the embodiment of FIG. 5, the negative electrode participation end point nf is a point corresponding to capacity 45 [Ah] in the adjusted negative electrode profile Rn'.

The negative electrode change rate ns may mean the change rate [%] of the adjusted negative electrode profile Rn' with respect to the criterion negative electrode profile Rn. Specifically, the negative electrode change rate ns may be the contraction ratio or expansion ratio of the adjusted negative electrode profile Rn' with respect to the criterion negative electrode profile Rn. For example, if the adjusted negative electrode profile Rn' is 10% shrinkage from the criterion negative electrode profile Rn, the negative electrode change rate ns is 90%. Conversely, if the adjusted negative electrode profile Rn' is 10% extension from the criterion negative electrode profile Rn, the negative electrode change rate ns is 110%.

The apparatus 100 for managing a battery according to an embodiment of the present disclosure has an advantage of estimating the positive electrode profile and the negative electrode profile of a battery, which cannot be measured directly, by adjusting the criterion positive electrode profile Rp and the criterion negative electrode profile Rn. Additionally, because the apparatus 100 for managing a battery can determine a diagnosis factor indicating the current state of the battery, the current state of the battery can be diagnosed based on the diagnosis factor. In other words, the apparatus 100 for managing a battery has an advantage of determining diagnosis factors that can diagnose the current state of the battery in a non-destructive manner.

For example, it is assumed that the control unit 130 determines the positive electrode change rate ps as a diagnosis factor. The control unit 130 can compare the determined positive electrode change rate ps and a criterion rate preset for the battery. Additionally, the control unit 130 can diagnose the state of the battery based on the ratio difference between the positive electrode change rate ps and the criterion rate. If the calculated ratio difference is greater than or equal to the threshold, the control unit 130 may diagnose the state of the battery as an abnormal or deteriorated state. Conversely, if the ratio difference is less than the threshold, the control unit 130 may diagnose the state of the battery as a normal state.

As another example, it is assumed that the control unit 130 determines the positive electrode change rate ps for the plurality of batteries as a diagnosis factor. The control unit 130 can diagnose the relative degree of degradation for the plurality of batteries by comparing the magnitude of the determined plurality of positive electrode change rates ps. For example, the control unit 130 can diagnose that as the determined positive electrode change rate ps is larger, the battery is relatively degraded more.

In the above, an embodiment in which the control unit 130 diagnoses the state of the battery using the positive electrode change rate ps has been described, but it should be noted that the state of the battery can be diagnosed based on at least one of the diagnosis factors.

Additionally, the control unit 130 may diagnose the state of the battery by combining diagnosis results for a plurality of diagnosis factors. For example, the control unit 130 may diagnose the state of the battery based on the majority of diagnosis results among the plurality of diagnosis factors.

Meanwhile, the control unit 130 included in the apparatus 100 for managing a battery optionally include a processor, an application-specific integrated circuit (ASIC), other chipset, a logic circuit, a register, a communication modem, a data processing device, etc. known in the art to execute various control logics performed in the present disclosure. Also, when the control logic is implemented as software, the control unit 130 may be implemented as a set of program modules. At this time, the program module may be stored in the memory and executed by the control unit 130. The memory may be inside or outside the control unit 130 and may be connected to the control unit 130 by various well-known means.

In addition, the apparatus 100 for managing a battery may further include a storage unit 140. The storage unit 140 may store data necessary for operation and function of each component of the apparatus 100 for managing a battery, data generated in the process of performing the operation or function, or the like. The storage unit 140 is not particularly limited in its kind as long as it is a known information storage means that can record, erase, update and read data. As an example, the information storage means may include RAM, flash memory, ROM, EEPROM, registers, and the like. In addition, the storage unit 140 may store program codes in which processes executable by the control unit 130 are defined.

For example, the storage unit 140 may store the criterion positive electrode profile Rp, the criterion negative electrode profile Rn, the criterion full-cell profile R, the measurement full-cell profile M, the adjusted positive electrode profile Rp', the adjusted negative electrode profile Rn', the comparison full-cell Profile S, the positive electrode factor, the negative electrode factor, etc.

Hereinafter, with reference to FIGS. 6 to 8, a first embodiment in which the profile determining unit 120 adjusts the criterion positive electrode profile Rp and the criterion negative electrode profile Rn will be described in detail.

Specifically, FIG. 6 is a diagram showing a full-cell differential profile D according to an embodiment of the present disclosure. FIG. 7 is a diagram showing the measurement full-cell profile M and a plurality of sections according to an embodiment of the present disclosure. FIG. 8 is a diagram showing the measurement full-cell profile M and the first comparison full-cell profile S1 according to an embodiment of the present disclosure.

The profile obtaining unit 110 may be configured to further obtain a full-cell differential profile D that corresponds to the measurement full-cell profile M and indicates the corresponding relationship between capacity and differential voltage.

Specifically, the full-cell differential profile D is a profile obtained by differentiating the measurement full-cell profile M with respect to capacity. In other words, the full-cell differential profile D is a profile that represents the corresponding relationship between capacity and differential voltage. Here, the differential voltage is a value obtained by differentiating voltage (V) with respect to capacity (Q), and can be expressed as "dV/dQ."

For example, in the embodiment of FIG. 6, the full-cell differential profile D can be expressed as a two-dimensional X-Y graph with the X-axis set to capacity [Ah] and the Y-axis set to differential voltage [dV/dQ].

For example, the profile obtaining unit 110 may directly receive the full-cell differential profile D of the battery from the outside. That is, the profile obtaining unit 110 can obtain the full-cell differential profile D by being connected to the outside in a wired and/or wireless manner and receiving the full-cell differential profile D.

As another example, the profile obtaining unit 110 may generate a full-cell differential profile D based on the received measurement full-cell profile M or the directly generated measurement full-cell profile M. That is, the profile obtaining unit 110 can obtain the full-cell differential profile D by directly generating the full-cell differential profile D by differentiating the measurement full-cell profile M with respect to capacity.

The profile obtaining unit 110 may transmit the obtained full-cell differential profile D to the profile determining unit 120.

The profile determining unit 120 may be configured to divide the measurement full-cell profile M into a plurality of sections based on at least one of the plurality of peaks included in the full-cell differential profile D.

Specifically, the peak refers to a point corresponding to the inflection point of the measurement full-cell profile M. In other words, the peak refers to a point in the full-cell differential profile D where the instantaneous rate of change of differential voltage relative to capacity is 0. For example, the maximum and minimum points of the full-cell differential profile D may be determined as peaks.

For example, in the embodiment of FIG. 6, the profile determining unit 120 may determine the first to seventh peaks p1 to p7 in the full-cell differential profile D. Here, the first peak p1, the third peak p3, the fifth peak p5, and the seventh peak p7 are peaks corresponding to the minimum point of the full-cell differential profile D, and the second peak p2, the fourth peak p4, and the sixth peak p6 are peaks corresponding to the maximum point of the full-cell differential profile D.

Specifically, the profile determining unit 120 may be configured to divide the measurement full-cell profile M into a plurality of sections based on the capacity of the plurality of peaks included in the full-cell differential profile D.

For example, in the embodiment of FIG. 7, the profile determining unit 120 may divide the measurement full-cell profile M into first to eighth sections R1 to R8 according to the plurality of capacities Q1 to Q7 corresponding to the first to seventh peaks p1 to p7. Here, the first section R1 is the capacity section of 0 [Ah] to Q1, the second section R2 is the capacity section of Q1 to Q2, and the third section R3 is the capacity section of Q2 to Q3. The fourth section R4 is the capacity section of Q3 to Q4, the fifth section R5 is the capacity section of Q4 to Q5, and the sixth section R6 is the capacity section of Q5 to Q6. The seventh section R7 is the capacity section of Q6 to Q7, and the eighth section R8 is the capacity section of Q7 to 45 [Ah].

Additionally, the profile determining unit 120 may be configured to adjust the criterion positive electrode profile Rp and the criterion negative electrode profile Rn to correspond to each of the plurality of sections. That is, the profile determining unit 120 may be configured to generate an adjusted positive electrode profile and an adjusted negative electrode profile corresponding to each of the plurality of sections.

Specifically, the criterion positive electrode profile Rp and the criterion negative electrode profile Rn can be adjusted to correspond to each section of the measurement full-cell profile M.

For example, in the embodiment of FIG. 7, the profile determining unit 120 may adjust the criterion positive electrode profile Rp and the criterion negative electrode profile Rn with respect to the first section R1 of the measurement full-cell profile M. Specifically, among the plurality of comparison full-cell profiles generated by the profile determining unit 120, the comparison full-cell profile that is most similar to the measurement full-cell profile M (e.g., has a small error) in the first section R1 may be specified. Additionally, the profile determining unit 120 may determine the first adjusted positive electrode profile Rp1' and the first adjusted negative electrode profile Rn1' corresponding to the specified comparison full-cell profile.

In the same manner, the profile determining unit 120 may determine second to eighth adjusted positive electrode profiles Rp2' to Rp8' and second to eighth adjusted negative electrode profiles Rp2' to Rp8' for each of the second to eighth sections R2 to R8 of the measurement full-cell profile M.

For example, in the embodiment of FIG. 8, the first adjusted positive electrode profile Rp1' and the first adjusted negative electrode profile Rn1' corresponding to the first section R1 may be determined, and the second adjusted positive electrode profile Rp2' and the second adjusted negative electrode profile Rn2' corresponding to the second section R2 may be determined. The third adjusted positive electrode profile Rp3' and the third adjusted negative electrode profile Rn3' corresponding to the third section R3 may be determined, and the fourth adjusted positive electrode profile Rp4' and the fourth adjusted negative electrode profile Rn4' corresponding to the fourth section R4 may be determined. The fifth adjusted positive electrode profile Rp5' and the fifth adjusted negative electrode profile Rn5' corresponding to the fifth section R5 may be determined, and the sixth adjusted positive electrode profile Rp6' and the sixth adjusted negative electrode profile Rn6' corresponding to the sixth section R6 may be determined. The seventh adjusted positive electrode profile Rp7' and the seventh adjusted negative electrode profile Rn7' corresponding to the seventh section R7 are determined, and the eighth adjusted positive electrode profile Rp8' and the eighth adjusted negative electrode profile Rn8' corresponding to the eighth section R8 may be determined.

The control unit 130 can determine the positive electrode factor from each of the plurality of adjusted positive electrode profiles Rp1' to Rp8' and determine the negative electrode factor from each of the plurality of adjusted negative electrode profiles Rn1' to Rn8'. Additionally, the control unit 130 may diagnose the state of the positive electrode of the battery in the corresponding section based on each of the determined plurality of positive electrode factors. Additionally, the control unit 130 may diagnose the state of the negative electrode of the battery in the corresponding section based on each of the determined plurality of negative electrode factors.

In the embodiment of FIG. 8, the control unit 130 may determine the positive electrode participation start points pi1 to pi8, the positive electrode participation end points pf1 to pf8, and the positive electrode change rates ps1 to ps8 of the first to eighth adjusted positive electrode profiles Rp1' to Rp8'. Likewise, the control unit 130 may determine the negative electrode participation start points ni1 to ni8, the negative electrode participation end points nf1 to nf8, and the negative electrode change rates ns1 to ns8 of the first to eighth adjusted negative electrode profiles Rn1' to Rn8'.

For example, the control unit 130 may determine the positive electrode deterioration degree for each of the first to eighth sections R1 to R8 by considering the plurality of positive electrode change rates ps1 to ps8. Specifically, the control unit 130 may determine the positive electrode change rate of each of the first to eighth sections R1 to R8 as the positive electrode deterioration degree in the corresponding section. Accordingly, the control unit 130 can determine the section in which the positive electrode is degraded most among the first to eighth sections R1 to R8.

As another example, the control unit 130 may determine the negative electrode degradation degree of each of the first to eighth sections R1 to R8 by considering the plurality of negative electrode change rates ns1 to ns8. Specifically, the control unit 130 may determine the negative electrode change rate for each of the first to eighth sections R1 to R8 as the negative electrode degradation degree in the corresponding section. Therefore, the control unit 130 can determine the section in which the negative electrode is degraded most among the first to eighth sections R1 to R8.

In the embodiment of FIG. 8, the profile determining unit 120 may determine the first comparison full-cell profile S1 corresponding to the measurement full-cell profile based on the first to eighth adjusted positive electrode profiles Rp1' to Rp8' and the first to eighth adjusted negative electrode profiles Rn1' to Rn8'. The control unit 130 may determine the positive electrode participation start point of the battery as pi1 and determine the positive electrode participation end point as pf8. Additionally, the control unit 130 may determine the negative electrode participation start point of the battery as ni1 and determine the negative electrode participation end point as nf8.

Preferably, the profile determining unit 120 can be configured to generate a plurality of adjusted positive electrode profiles Rp1' to Rp8' such that the end point of the adjusted positive electrode profile Rp' for the previous section is the same as the start point of the adjusted positive electrode profile Rp' for the next section. Similarly, the profile determining unit 120 can be configured to generate a plurality of adjusted negative electrode profiles Rn1' to Rn8' such that the end point of the adjusted negative electrode profile Rn' for the previous section is the same as the start point of the adjusted negative electrode profile Rn' for the next section.

Specifically, since the plurality of adjusted positive electrode profiles Rp1' to Rp8' are determined as the adjusted positive electrode profile Rp' of the battery as a whole, the plurality of adjusted positive electrode profiles Rp1' to Rp8' must be continuous. Likewise, the plurality of adjusted negative electrode profiles Rn1' to Rn8' must be continuous because they are determined as the adjusted negative electrode profile Rn' of the battery as a whole.

For example, in the embodiment of FIG. 8, the profile determining unit 120 may determine the positive electrode participation end point pf2 of the second adjusted positive electrode profile Rp2' after setting the positive electrode participation start point pi2 of the second adjusted positive electrode profile Rp2' to be equal to the positive electrode participation end point pf1 of the first adjusted positive electrode profile Rp1'. Likewise, the profile determining unit 120 may set each of the positive electrode participation start points pi3 to pi8 of the third to eighth adjusted positive electrode profiles Rp3' to Rp8' to correspond to each of the positive electrode participation end points pf2 to pf7 of the second to seventh adjusted positive electrode profiles Rp2' to Rp7'.

In addition, in the embodiment of FIG. 8, the profile determining unit 120 may determine the negative electrode participation end point nf2 of the second adjusted negative electrode profile Rn2' after setting the negative electrode participation start point ni2 of the second adjusted negative electrode profile Rn2' to be identical to the negative electrode participation end point nf1 of the first adjusted negative electrode profile Rn1'. Similarly, the profile determining unit 120 may determine each of the negative electrode participation start points ni3 to ni8 of the third to eighth adjusted negative electrode profiles Rn3' to Rn8' to correspond to each of the negative electrode participation end points nf2 to nf7 of the second to seventh adjusted negative electrode profiles Rn2' to Rn7'.

Also, in the embodiment of FIG. 8, the control unit 130 may determine the positive electrode participation start point of the adjusted positive electrode profile Rp' for the battery as pi1, and determine the positive electrode participation end point as pf8. Additionally, the control unit 130 may determine the negative electrode participation start point of the adjusted negative electrode profile Rn' for the battery as ni1, and determine the negative electrode participation end point as nf8.

The apparatus 100 for managing a battery according to an embodiment of the present disclosure may determine the positive electrode degradation degree and the negative electrode degradation degree of the battery for each of the plurality of sections by determining the adjusted positive electrode profile and the adjusted negative electrode profile for each of the plurality of sections. In other words, the apparatus 100 for managing a battery can estimate the positive electrode degradation degree and the negative electrode degradation degree for each detailed section, so it has an advantage of deriving a diagnosis factor that can more accurately diagnose the state of the battery. In addition, the apparatus 100 for managing a battery has an advantage of more accurately and precisely diagnosing the state of the positive electrode and the negative electrode of the battery through the derived diagnosis factor.

Hereinafter, with reference to FIGS. 9 to 11, a second embodiment in which the profile determining unit 120 adjusts the criterion positive electrode profile Rp and the criterion negative electrode profile Rn will be described in detail.

FIG. 9 is a diagram showing a full-cell differential profile D according to an embodiment of the present disclosure. FIG. 10 is a diagram showing the measurement full-cell profile M and a plurality of sections R1 to R5 according to an embodiment of the present disclosure. FIG. 11 is a diagram showing the measurement full-cell profile M and the second comparison full-cell profile S2 according to an embodiment of the present disclosure.

The profile determining unit 120 may be configured to divide the measurement full-cell profile M into a plurality of sections R1 to R5 based on the plurality of reference peaks included in the full-cell differential profile D.

Specifically, the reference peak is a peak corresponding to the minimum point of the full-cell differential profile D. For example, in the embodiment of FIG. 9, the plurality of reference peaks may include a first peak p1, a third peak p3, a fifth peak p5, and a seventh peak p7.

In the embodiment of FIG. 10, the profile determining unit 120 may divide the measurement full-cell profile M into first to fifth sections R1 to R5 according to the plurality of capacities Q1, Q3, Q5, and Q7 corresponding to the reference peaks p1, p3, p5, and p7. Here, the first section R1 is the capacity section of 0 [Ah] to Q1, the second section R2 is the capacity section of Q1 to Q3, and the third section R3 is the capacity section of Q3 to Q5. The fourth section R4 is the capacity section of Q5 to Q7, and the fifth section R5 is the capacity section of Q7 to 45 [Ah].

The profile determining unit 120 may be configured to set a weight for each of the plurality of sections R1 to R5.

Here, the weight set for each of the plurality of sections R1 to R5 is a value between 0 and 1, and the total sum of the set weights is 1.

For example, the control unit 130 can set the weight of the first to fifth sections R1 to R5 to 0.2, respectively.

As another example, the control unit 130 may set the weight of the first to fifth sections R1 to R5 according to the importance of the first to fifth sections R1 to R5. Specifically, some of the plurality of sections R1 to R5 are sections that reflect the state of the positive electrode of the battery, and others are sections that reflect the state of the negative electrode of the battery. Accordingly, the control unit 130 may set the importance of the section corresponding to the item to be diagnosed among the plurality of sections R1 to R5 high. Also, the weight for a section with high importance may be set to be larger than the weight for other sections.

Specifically, the profile determining unit 120 may be configured to set the weight for the target section including at least one of the plurality of target peaks included in the full-cell differential profile D to be larger than the weight for the remaining sections.

Specifically, the target peak is a peak corresponding to the maximum point of the full-cell differential profile D. For example, in the embodiment of FIG. 9, the plurality of target peaks may include the second peak p2, the fourth peak p4, and the sixth peak p6.

The control unit 130 may select at least one of the plurality of target peaks according to the diagnosis object and determine the section including the selected target peak as the target section. For example, if the diagnosis item is the state of the negative electrode, the control unit 130 may determine the second section R2, which includes the second peak p2, as the target section, and set the weight for the second section R2 to be the largest. As another example, when the diagnosis item is the state of the positive electrode, the control unit 130 may determine the fourth section R4, which includes the sixth peak p6, as the target section, and set the weight for the fourth section R4 to be the largest.

The profile determining unit 120 may be configured to adjust the criterion positive electrode profile Rp and the criterion negative electrode profile Rn based on the weight to correspond to the measurement full-cell profile M.

Specifically, the profile determining unit 120 may be configured to generate a second comparison full-cell profile S2 based on the adjusted positive electrode profile Rp' and the adjusted negative electrode profile Rn'.

For example, the profile determining unit 120 may generate a plurality of comparison full-cell profiles by shifting the criterion positive electrode profile Rp and the criterion negative electrode profile Rn or performing capacity scaling thereto. In the embodiment of FIG. 11, the profile determining unit 120 may determine the second comparison full-cell profile S2 corresponding to the measurement full-cell profile M based on the adjusted positive electrode profile Rp' and the adjusted negative electrode profile Rn'. The control unit 130 may determine the positive electrode participation start point of the battery as pi and determine the positive electrode participation end point as pf. Additionally, the control unit 130 may determine the negative electrode participation start point of the battery as ni and determine the negative electrode participation end point as nf.

Additionally, the profile determining unit 120 may be configured to adjust the criterion positive electrode profile Rp and the criterion negative electrode profile Rn so that the error rate between the comparison full-cell profile S and the measurement full-cell profile M decreases as the section has a larger set weight.

For example, the profile determining unit 120 may specify a comparison full-cell profile with a low error rate in the order of the largest weight among the plurality of sections R1 to R5 of the measurement full-cell profile M among the plurality of comparison full-cell profiles. Assuming that hundred comparison full-cell profiles are generated and the target section is the second section R2, the profile determining unit 120 may specify the second comparison full-cell profile S2 with the lowest error rate in the second section R2 among the hundred comparison full-cell profiles. Additionally, the profile determining unit 120 may determine the adjusted positive electrode profile Rp' and the adjusted negative electrode profile Rn' corresponding to the specified second comparison full-cell profile S2. If there are a plurality of comparison full-cell profiles with the lowest error rate in the second section R2, the profile determining unit 120 may specify the second comparison full-cell profile S2 with the lower overall error rate for the entire capacity section of the measurement full-cell profile M.

The apparatus 100 for managing a battery according to an embodiment of the present disclosure has an advantage of determining a diagnosis factor that better reflects the state of the battery because it adjusts the criterion positive electrode profile Rp and the criterion negative electrode profile Rn to correspond to the diagnosis item. In other words, because the optimal diagnosis factor corresponding to the diagnosis item can be determined, the state of the battery can be diagnosed more accurately.

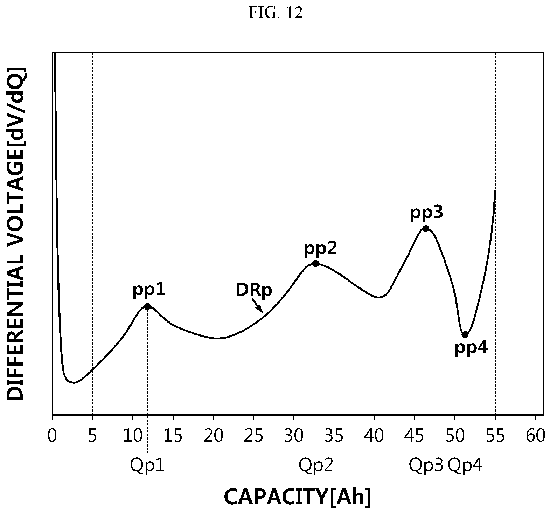

Hereinafter, with reference to FIGS. 12 to 15, a third embodiment in which the profile determining unit 120 adjusts the criterion positive electrode profile Rp and the criterion negative electrode profile Rn will be described in detail.

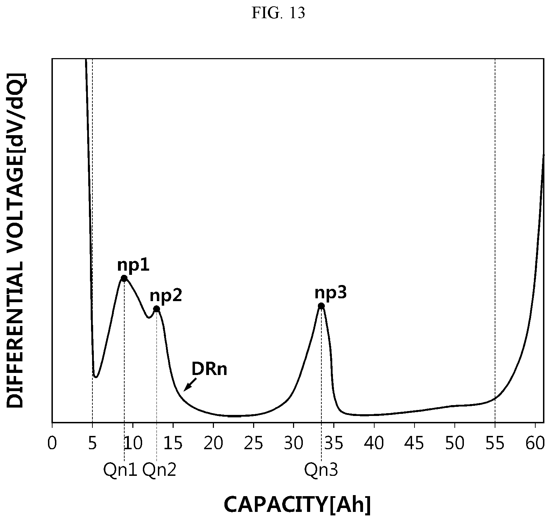

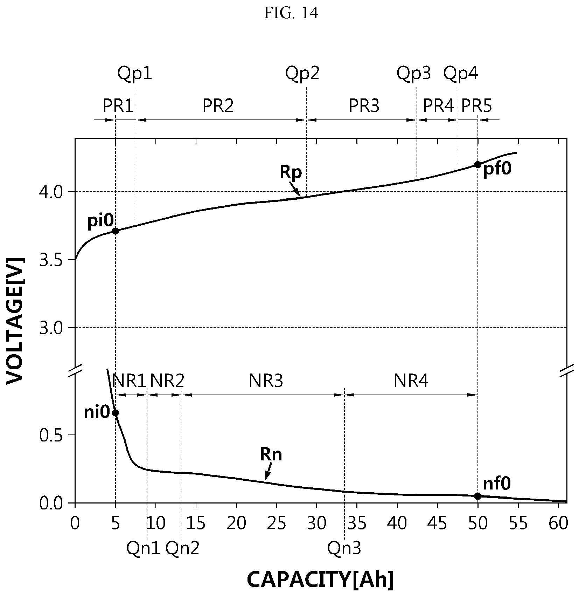

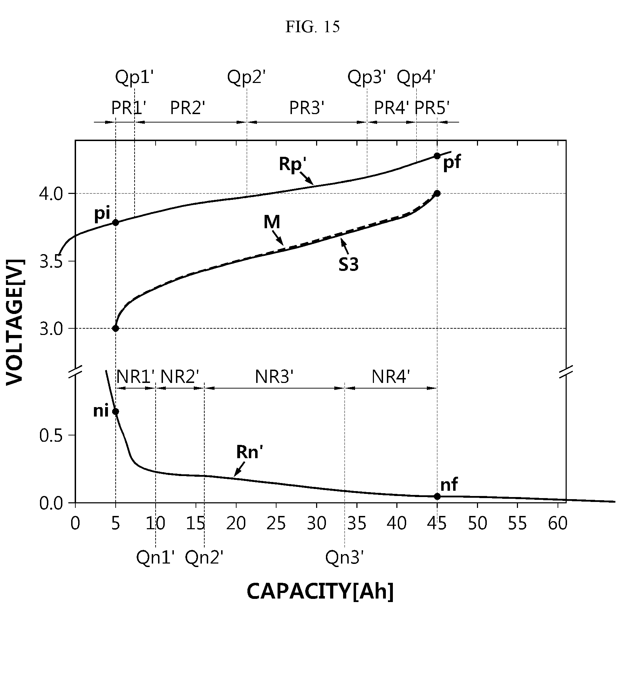

FIG. 12 is a diagram showing a positive electrode differential profile DRp according to an embodiment of the present disclosure. FIG. 13 is a diagram showing a negative electrode differential profile DRn according to an embodiment of the present disclosure. FIG. 14 is a diagram showing a criterion positive electrode profile Rp and a criterion negative electrode profile Rn according to an embodiment of the present disclosure. FIG. 15 is a diagram showing the measurement full-cell profile M and the third comparison full-cell profile S3 according to an embodiment of the present disclosure.

The profile obtaining unit 110 may be configured to obtain at least one of the positive electrode differential profile DRp corresponding to the criterion positive electrode profile Rp and the negative electrode differential profile DRn corresponding to the criterion negative electrode profile Rn as an electrode differential profile.

Specifically, the positive electrode differential profile DRp is a profile obtained by differentiating the criterion positive electrode profile Rp with respect to capacity. The negative electrode differential profile DRn is a profile obtained by differentiating the criterion negative electrode profile Rn with respect to capacity.

For example, in the embodiment of FIG. 12, the positive electrode differential profile DRp can be expressed as a two-dimensional X-Y graph with the X-axis set to capacity [Ah] and the Y-axis set to differential voltage [dV/dQ]. In the embodiment of FIG. 13, the negative electrode differential profile DRn can be expressed as a two-dimensional X-Y graph with the X-axis set to capacity [Ah] and the Y-axis set to differential voltage [dV/dQ].

For example, the profile obtaining unit 110 may directly receive the positive electrode differential profile DRp and the negative electrode differential profile DRn of the battery from the outside. That is, the profile obtaining unit 110 can receive information from the outside by wired and/or wirelessly. As another example, the profile obtaining unit 110 may generate a positive electrode differential profile DRp and a negative electrode differential profile DRn based on the criterion positive electrode profile Rp and the criterion negative electrode profile Rn.

The profile determining unit 120 may be configured to divide a corresponding criterion electrode profile among the criterion positive electrode profile Rp and the criterion negative electrode profile Rn into a plurality of electrode sections based on at least one of a plurality of electrode peaks included in the electrode differential profile

Specifically, the positive electrode differential profile DRp may include a plurality of positive electrode peaks, and the negative electrode differential profile DRn may include a plurality of negative electrode peaks.

In the embodiment of FIG. 12, the positive electrode differential profile DRp may include first to fourth positive electrode peaks pp1, pp2, pp3, and pp4. Specifically, the positive electrode peak may include a peak corresponding to the maximum point of the positive electrode differential profile DRp. The positive electrode peak may include a peak corresponding to the minimum point with the largest capacity among the plurality of maximum points of the positive electrode differential profile DRp. The capacity of the first positive electrode peak pp1 is Qp1, the capacity of the second positive electrode peak pp2 is Qp2, the capacity of the third positive electrode peak pp3 is Qp3, and the capacity of the fourth positive electrode peak pp4 is Qp4.

In the embodiment of FIG. 13, the negative electrode differential profile DRn may include first to third negative electrode peaks np1, np2, np3. Specifically, the negative electrode peak may include a peak corresponding to the maximum point of the negative electrode differential profile DRn. The capacity of the first negative electrode peak np1 is Qn1, the capacity of the second negative electrode peak np2 is Qn2, and the capacity of the third negative electrode peak np3 is Qn3.

In the embodiment of FIG. 14, the profile determining unit 120 may divide the criterion positive electrode profile Rp into first to fifth positive electrode sections PR1 to PR5. The first positive electrode section PR1 is a capacity section of 5 [Ah] to Qp1, and the second positive electrode section PR2 is a capacity section of Qp1 to Qp2. The third positive electrode section PR3 is a capacity section of Qp2 to Qp3, the fourth positive electrode section PR4 is a capacity section of Qp3 to Qp4, and the fifth positive electrode section PR5 is a capacity section of Qp4 to 50 [Ah].

Additionally, the profile determining unit 120 may divide the criterion negative electrode profile Rn into first to fourth negative electrode sections NR1 to NR4. The first negative electrode section NR1 is a capacity section of 5 [Ah] to Qn1, and the second negative electrode section NR2 is a capacity section of Qn1 to Qn2. The third negative electrode section NR3 is a capacity section of Qn2 to Qn3, and the fourth negative electrode section NR4 is a capacity section of Qn3 to 50 [Ah].

The profile determining unit 120 may be configured to adjust the criterion positive electrode profile Rp and the criterion negative electrode profile Rn to correspond to the measurement full-cell profile M while adjusting each of the plurality of electrode sections.

Specifically, the profile determining unit 120 may be configured to independently adjust each of the plurality of electrode sections. That is, the profile determining unit 120 can determine the adjusted positive electrode profile Rp' and the adjusted negative electrode profile Rn' corresponding to the measurement full-cell profile M by independently adjusting the change rate of each of the plurality of electrode sections.

The adjusted positive electrode profile Rp' can be divided into a plurality of adjusted positive electrode sections PR1' to PR5', and the adjusted negative electrode profile Rn' can be divided into a plurality of adjusted negative electrode sections NR1' to NR4'. Each of the plurality of adjusted positive electrode sections PR1' to PR5' is obtained by changing each of the plurality of positive electrode sections PR1 to PR5 of the criterion positive electrode profile Rp, and each of the plurality of adjusted negative electrode sections NR1' to NR4' is obtained by changing each of the plurality of negative electrode sections NR1 to NR4 of the criterion negative electrode profile Rn.

For example, in the embodiment of FIG. 15, the adjusted positive electrode profile Rp' can be divided into the first to fifth adjusted positive electrode sections PR1' to PR5', and each of the first to fifth adjusted positive electrode sections PR1' to PR5' corresponds to each of the first to fifth positive electrode sections PR1 to PR5 of the positive electrode profile Rp. The first adjusted positive electrode section PR1' is a section obtained by changing the first positive electrode section PR1, and the second adjusted positive electrode section PR2' is a section obtained by changing the second positive electrode section PR2. The third adjusted positive electrode section PR3' is a section obtained by changing the third positive electrode section PR3, the fourth adjusted positive electrode section PR4' is a section obtained by changing the fourth positive electrode section PR4, and the fifth adjusted positive electrode section PR5' is a section obtained by changing the fifth positive electrode section PR5. The control unit 130 may determine the positive electrode participation start point pi and the positive electrode participation end point pf of the adjusted positive electrode profile Rp'. Additionally, the control unit 130 may determine the positive electrode change rate ps1 to ps5 for each of the first to fifth adjusted positive electrode sections RP1' to PR5'. For example, the control unit 130 may determine the ratio of the first adjusted positive electrode section PR1' to the first positive electrode section PR1 as the positive electrode change rate ps1 to the first adjusted positive electrode section PR1'. That is, the control unit 130 may determine the positive electrode change rates ps1 to ps5 to the plurality of adjusted positive electrode sections RP1' to PR5' by calculating the change rate of the adjusted positive electrode sections RP1' to PR5' with respect to the positive electrode sections PR1 to PR5. Likewise, the control unit 130 may determine the positive electrode change rates ps2 to ps5 for the second to fifth adjusted positive electrode sections PR2' to PR5'.

Likewise, in the embodiment of FIG. 15, the adjusted negative electrode profile Rn' can be divided into first to fourth adjusted negative electrode sections NR1' to NR4', and each of the first to fourth adjusted negative electrode sections NR1' to NR4' corresponds to each of the first to fourth negative electrode sections NR1 to NR4 of the criterion negative electrode profile Rn. The first adjusted negative electrode section NR1' is a section obtained by changing the first negative electrode section NR1, and the second adjusted negative electrode section NR2' is a section obtained by changing the second negative electrode section NR2. The third adjusted negative electrode section NR3' is a section obtained by changing the third negative electrode section NR3, and the fourth adjusted negative electrode section NR4' is a section obtained by changing the fourth negative electrode section NR4. The control unit 130 may determine the negative electrode participation start point ni and the negative electrode participation end point nf of the adjusted negative electrode profile Rn'. Additionally, the control unit 130 may determine the negative electrode change rate ns1 to ns4 for each of the first to fourth adjusted negative electrode sections NR1' to NR4'. For example, the control unit 130 may determine the ratio of the first adjusted negative electrode section NR1' to the first negative electrode section NR1 as the negative electrode change rate ns1 to the first adjusted negative electrode section NR1'. That is, the control unit 130 may determine the negative electrode change rate for the plurality of adjusted negative electrode sections NR1' to NR4' by calculating the change rate of the adjusted negative electrode sections NR1' to NR4' with respect to the negative electrode sections NR1 to NR4. Likewise, the control unit 130 may determine the negative electrode change rates ns2 to ns4 for the second to fourth adjusted negative electrode sections NR2' to NR4'.

The profile determining unit 120 may determine the third comparison full-cell profile S3 corresponding to the measurement full-cell profile M based on the adjusted positive electrode profile Rp' and the adjusted negative electrode profile Rn'. In the embodiment of FIG. 15, the control unit 130 may determine the positive electrode participation start point of the battery as pi and determine the positive electrode participation end point as pf. Additionally, the control unit 130 may determine the negative electrode participation start point of the battery as ni and determine the negative electrode participation end point as nf.

In other words, when the positive electrode differential profile DRp is included in the electrode differential profile, the profile determining unit 120 may be configured to divide the criterion positive electrode profile Rp into a plurality of positive electrode sections based on at least one of the plurality of positive electrode peaks included in the positive electrode differential profile DRp. In addition, when the negative electrode differential profile DRn is included in the electrode differential profile, the profile determining unit 120 may be configured to divide the criterion negative electrode profile Rn into a plurality of negative electrode sections based on at least one of the plurality of negative electrode peaks included in the negative electrode differential profile DRn. In the above, with reference to FIGS. 12 to 14, an embodiment in which both the positive electrode differential profile DRp and the negative electrode differential profile DRn are included in the electrode differential profile so that the criterion positive electrode profile Rp is divided into a plurality of positive electrode sections and the criterion negative electrode profile Rn is divided into a plurality of negative electrode sections has been described. However, depending on the embodiment, the positive electrode differential profile DRp or the negative electrode differential profile DRn may be included in the electrode differential profile.

The apparatus 100 for managing a battery according to an embodiment of the present disclosure may determine an adjusted positive electrode profile and an adjusted negative electrode profile by adjusting the plurality of positive electrode sections and/or the plurality of negative electrode sections, respectively. In other words, the apparatus 100 for managing a battery has an advantage of determining detailed diagnosis factors for the battery. Therefore, based on the diagnosis factors, the state of the battery can be diagnosed in more detail and accurately.

The apparatus 100 for managing a battery according to the present disclosure can be applied to the BMS. In other words, the BMS according to the present disclosure may include the above-described apparatus 100 for managing a battery. In this configuration, at least some of the components of the apparatus 100 for managing a battery may be implemented by supplementing or adding functions of components included in a conventional BMS. For example, the profile obtaining unit 110, the profile determining unit 120, the control unit 130 and the storage unit 140 of the apparatus 100 for managing a battery may be implemented as components of a BMS.

Additionally, the apparatus 100 for managing a battery according to the present disclosure may be provided in the battery pack. That is, the battery pack according to the present disclosure may include the above-described apparatus 100 for managing a battery and at least one battery cell. Additionally, the battery pack may further include electrical components (relays, fuses, etc.) and a case.

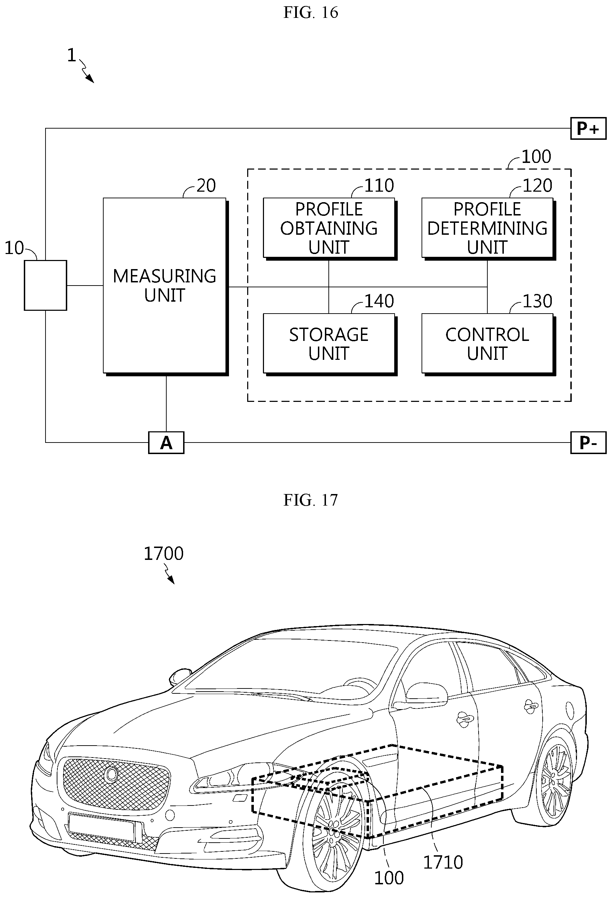

FIG. 16 is a diagram showing an exemplary configuration of the battery pack including according to another embodiment of the present disclosure.

The positive electrode terminal of the battery 10 may be connected to the positive electrode terminal P+ of the battery pack 1, and the negative electrode terminal of the battery 10 may be connected to the negative electrode terminal P- of the battery pack 1.

The measuring unit 20 can be connected to the positive electrode terminal and the negative electrode terminal of the battery 10. Additionally, the measuring unit 20 can measure the voltage of the battery 10 by measuring the positive electrode potential and the negative electrode potential of the battery 10 and calculating the difference between the positive electrode potential and the negative electrode potential.

In addition, the measuring unit 20 can be connected to a current measurement unit A. For example, the current measurement unit A may be an ammeter or shunt resistor that can measure the charging current and discharging current of the battery 10. The measuring unit 20 can calculate the charging amount by measuring the charging current of the battery 10 using the current measurement unit A. Additionally, the measuring unit 20 can calculate the discharge amount by measuring the discharge current of the battery 10 through the third sensing line SL3.

For example, the information about the voltage and capacity of the battery 10 measured by the measuring unit 20 may be transmitted to the profile obtaining unit 110. Additionally, the profile obtaining unit 110 can directly generate a measurement full-cell profile M based on the received information about the voltage and capacity.

As another example, the information about the voltage and capacity of the battery 10 measured by the measuring unit 20 may be stored in the storage unit 140. When the charging or discharging of the battery 10 is completed, the profile obtaining unit 110 may access the storage unit 140 to obtain the measurement full-cell profile M.

As still another example, the measuring unit 20 may directly generate a measurement full-cell profile M based on the measured information about the voltage and capacity of the battery 10. In this case, the generated measurement full-cell profile M may be transmitted to the profile obtaining unit 110 and also be stored in the storage unit 140.

A charge/discharge device or load can be connected to the positive electrode terminal P+ and the negative electrode terminal P- of the battery pack 1.

FIG. 17 is a diagram schematically showing a vehicle 1700 according to still another embodiment of the present disclosure.

Referring to FIG. 17, the battery pack according to an embodiment of the present disclosure may be included in a vehicle 1700 such as an electric vehicle (EV) or a hybrid vehicle (HV). In addition, the battery pack 1710 may drive the vehicle 1700 by supplying power to a motor through an inverter included in the vehicle 1700. Here, the battery pack 1710 may include the apparatus 100 for managing a battery. That is, the vehicle 1700 may include the apparatus 100 for managing a battery. In this case, the apparatus 100 for managing a battery may be an on-board diagnostic device included in the vehicle 1700.

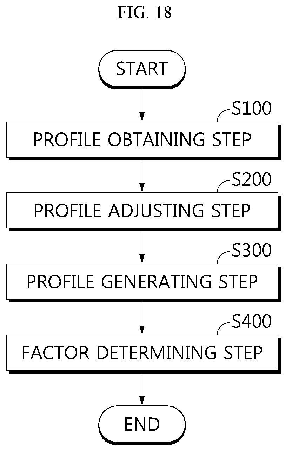

FIG. 18 is a diagram schematically showing a method for managing a battery according to still another embodiment of the present disclosure.

Referring to FIG. 18, the method for managing a battery may include a profile obtaining step (S100), a profile adjusting step (S200), a profile generating step (S300), and a factor determining step (S400).

Preferably, each step of the method for managing a battery can be performed by the apparatus 100 for managing a battery. Hereinafter, for convenience of explanation, content that overlaps with the content described above will be omitted or briefly described.

The profile obtaining step (S100) is a step of obtaining a measurement full-cell profile M indicating the corresponding relationship between the voltage and capacity of the battery, and can be performed by the profile obtaining unit 110.

For example, the profile obtaining unit 110 may directly receive the measurement full-cell profile M of the battery from the outside. That is, the profile obtaining unit 110 can obtain the measurement full-cell profile M by being connected to the outside by wired and/or wirelessly and receiving the measurement full-cell profile M.

As another example, the profile obtaining unit 110 may receive battery information about the voltage and capacity of the battery. Also, the profile obtaining unit 110 can obtain the measurement full-cell profile M by generating the measurement full-cell profile M based on the received battery information.

The profile adjusting step (S200) is a step of adjusting the preset criterion positive electrode profile Rp and the criterion negative electrode profile Rn to correspond to the measurement full-cell profile M or a plurality of sections of the measurement full-cell profile M, and can be performed by the profile determining unit 120.

In one embodiment, when the measurement full-cell profile M is divided into a plurality of sections, the profile determining unit 120 may adjust a criterion positive electrode profile Rp and a criterion negative electrode profile Rn to correspond to each section of the measurement full-cell profile M. Here, when the plurality of sections are divided in the number of n (n is a natural number of 2 or more), the criterion positive electrode profile Rp and the criterion negative electrode profile Rn can be adjusted for the n sections. That is, one adjustment result (see FIG. 11) or n adjustment results (see FIG. 8) for the criterion positive electrode profile Rp and the criterion negative electrode profile Rn can be derived.

In the embodiment of FIG. 8, the profile determining unit 120 may adjust the criterion positive electrode profile Rp and the criterion negative electrode profile Rn to correspond to each of the first to eighth sections R1 to R8. In this case an adjustment result each of the first to eighth sections R1 to R8 may be derived. That is, eight adjustment results for the criterion positive electrode profile Rp and the criterion negative electrode profile Rn can be derived.

In the embodiment of FIG. 11, the profile determining unit 120 may determine the target section in the first to fifth sections R1 to R5 of the measurement full-cell profile M, and adjust the criterion positive electrode profile Rp and the criterion negative electrode profile Rn so that the error rate in the target section is lowest. In this case, one adjustment result for the criterion positive electrode profile Rp and the criterion negative electrode profile Rn can be derived.

In another embodiment, when the measurement full-cell profile M is not divided into a plurality of sections, the profile determining unit 120 may adjust the criterion positive electrode profile Rp and the criterion negative electrode profile Rn to correspond to the entire section of the measurement full-cell profile M. Here, one adjustment result for the criterion positive electrode profile Rp and the criterion negative electrode profile Rn can be derived.

In the embodiment of FIG. 15, the profile determining unit 120 may divide the criterion positive electrode profile Rp and/or the criterion negative electrode profile Rn into a plurality of electrode sections, and adjust each of the plurality of electrode sections to correspond to the measurement full-cell profile M.

The profile generating step (S300) is a step of generating an adjusted positive electrode profile Rp' and an adjusted negative electrode profile Rn' according to the adjustment result, and can be performed by the profile determining unit 120.

For example, in the embodiment of FIG. 8, the profile determining unit 120 may determine first to eighth adjusted positive electrode profiles Rp1' to Rp8' and first to eighth adjusted negative electrode profiles Rn1' to Rn8' for the first to eighth sections R1 to R8. The first comparison full-cell profile S1 can be determined based on the plurality of adjusted positive electrode profiles Rp1' to Rp8' and the plurality of adjusted negative electrode profiles Rn1' to Rn8'.

As another example, in the embodiment of FIG. 11, the profile determining unit 120 may determine the adjusted positive electrode profile Rp' and the adjusted negative electrode profile Rn' that have the lowest error rate for the determined target section. The second comparison full-cell profile S2 can be determined based on the adjusted positive electrode profile Rp' and the adjusted negative electrode profile Rn'.

As still another example, in the embodiment of FIG. 15, the profile determining unit 120 may determine the adjusted positive electrode profile Rp' and the adjusted negative electrode profile Rn' by adjusting the first to fifth positive electrode sections PR1 to PR5 and the first to fourth negative electrode sections NR1 to NR4, respectively. The third comparison full-cell profile S3 can be determined based on the adjusted positive electrode profile Rp' and the adjusted negative electrode profile Rn'.

The factor determining step (S400) is a step of determining a positive electrode factor for the battery from the adjusted positive electrode profile Rp' and a negative electrode factor for the battery from the adjusted negative electrode profile Rn', and can be performed by the control unit 130.

Specifically, the control unit 130 may determine the positive electrode participation start point, the positive electrode participation end point, and the positive electrode change rate in the adjusted positive electrode profile Rp', and determine the negative electrode participation start point, the negative electrode participation end point, and the negative electrode change rate in adjusted negative electrode profile Rn'.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

1: battery pack
10: battery
20: measuring unit
100: apparatus for managing a battery
110: profile obtaining unit
120: profile determining unit
130: control unit
140: storage unit
1700: vehicle
1710: battery pack

## Claims

1. An apparatus for managing a battery, comprising:
a profile obtaining unit configured to obtain a measurement full-cell profile indicating a corresponding relationship between voltage and capacity of a battery;
a profile determining unit configured to adjust a preset criterion positive electrode profile and a preset criterion negative electrode profile to correspond to the measurement full-cell profile or a plurality of sections of the measurement full-cell profile, and generate an adjusted positive electrode profile and an adjusted negative electrode profile according to the adjustment result; and
a control unit configured to determine a diagnosis factor for the battery from at least one of the adjusted positive electrode profile and the adjusted negative electrode profile.

2. The apparatus for managing a battery according to claim 1,
wherein the profile obtaining unit is configured to further obtain a full-cell differential profile corresponding to the measurement full-cell profile and indicating a corresponding relationship between capacity and differential voltage, and
wherein the profile determining unit is configured to divide the measurement full-cell profile into the plurality of sections based on at least one of a plurality of peaks included in the full-cell differential profile.

3. The apparatus for managing a battery according to claim 2,
wherein the profile determining unit is configured to divide the measurement full-cell profile into the plurality of sections based on capacities of the plurality of peaks included in the full-cell differential profile.

4. The apparatus for managing a battery according to claim 2,
wherein the profile determining unit is configured to generate the adjusted positive electrode profile and the adjusted negative electrode profile corresponding to each of the plurality of sections by adjusting the criterion positive electrode profile and the criterion negative electrode profile to correspond to each of the plurality of sections.

5. The apparatus for managing a battery according to claim 4,
wherein the profile determining unit is configured to generate a plurality of adjusted positive electrode profiles such that an end point of the adjusted positive electrode profile for a previous section is the same as a start point of the adjusted positive electrode profile for a next section, and generate a plurality of adjusted negative electrode profiles such that an end point the adjusted negative electrode profile for the previous section is the same as the start point of the adjusted negative electrode profile for the next section.

6. The apparatus for managing a battery according to claim 2,
wherein the profile determining unit is configured to divide the measurement full-cell profile into the plurality of sections based on a plurality of reference peaks included in the full-cell differential profile.

7. The apparatus for managing a battery according to claim 6,
wherein the profile determining unit is configured to set a weight for each of the plurality of sections and adjust the criterion positive electrode profile and the criterion negative electrode profile based on the weight to correspond to the measurement full-cell profile.

8. The apparatus for managing a battery according to claim 7,
wherein the profile determining unit is configured to set the weight for a target section containing at least one of the plurality of target peaks included in the full-cell differential profile to be larger than the weight for the remaining sections.

9. The apparatus for managing a battery according to claim 7,
wherein the profile determining unit is configured to generate a comparison full-cell profile based on the adjusted positive electrode profile and the adjusted negative electrode profile, and adjust the criterion positive electrode profile and the criterion negative electrode profile such that as the section has a larger set weight, an error rate between the comparison full-cell profile and the measurement full-cell profile is lowered.

10. The apparatus for managing a battery according to claim 1,
wherein the profile obtaining unit is configured to obtain at least one of a positive electrode differential profile corresponding to the criterion positive electrode profile and a negative electrode differential profile corresponding to the criterion negative electrode profile as an electrode differential profile, and
wherein the profile determining unit is configured to divide a corresponding criterion electrode profile among the criterion positive electrode profile and the criterion negative electrode profile into a plurality of electrode sections based on at least one of a plurality of electrode peaks included in the electrode differential profile, and adjust the criterion positive electrode profile and the criterion negative electrode profile to correspond to the measurement full-cell profile, while adjusting each of the plurality of electrode sections.

11. The apparatus for managing a battery according to claim 10,
wherein the profile determining unit is configured to independently adjust each of the plurality of electrode sections.

12. The apparatus for managing a battery according to claim 10,
wherein when the positive electrode differential profile is included in the electrode differential profile, the profile determining unit is configured to divide the criterion positive electrode profile into a plurality of positive electrode sections based on at least one of the plurality of positive electrode peaks included in the positive electrode differential profile, and
wherein when the negative electrode differential profile is included in the electrode differential profile, the profile determining unit is configured to divide the criterion negative electrode profile into a plurality of negative electrode sections based on at least one of the plurality of negative electrode peaks included in the negative electrode differential profile.

13. A battery pack, comprising the apparatus for managing a battery according to any one of claims 1 to 12.

14. A vehicle, comprising the apparatus for managing a battery according to any one of claims 1 to 12.

15. A method for managing a battery, comprising:
a profile obtaining step of obtaining a measurement full-cell profile indicating a corresponding relationship between voltage and capacity of a battery;
a profile adjusting step of adjusting a preset criterion positive electrode profile and a preset criterion negative electrode profile to correspond to the measurement full-cell profile or a plurality of sections of the measurement full-cell profile;
a profile generating step of generating an adjusted positive electrode profile and an adjusted negative electrode profile according to the adjustment result; and
a factor determining step of determining a diagnosis factor for the battery from at least one of the adjusted positive electrode profile and the adjusted negative electrode profile.
